# EUROPEAN PATENT SPECIFICATION

(11) **EP 3 919 652 B1**
(45) Date of publication and mention of the grant of the patent: **01.11.2023**
(21) Application number: 20749792.6
(22) Date of filing: 23.01.2020
(51) Int. Cl.: C23C 16/455, C23C 16/44, C23C 16/458

(54) **COATING DEVICE**
BESCHICHTUNGSVORRICHTUNG
DISPOSITIF DE REVÊTEMENT

(30) Priority: 31.01.2019 KR 20190012719
(43) Date of publication of application: 08.12.2021
(73) Proprietor: LG Energy Solution, Ltd., Seoul 07335 (KR)
(72) Inventor: PARK, Sang Joon, Daejeon 34122 (KR); KIM, Ki Hwan, Daejeon 34122 (KR); LEE, Eun Jeong, Daejeon 34122 (KR); KIM, Yong Chan, Daejeon 34122 (KR)
(74) Representative: Goddar, Heinz J.
(86) International application number: PCT/KR2020/001174
(87) International publication number: WO 2020/159162

(56) References cited:
- CN-A- 105 951 058
- KR-A- 20080 101 494
- KR-A- 20150 013 296
- KR-A- 20150 108 832
- KR-B1- 101 868 703
- US-A1- 2006 073 276
- US-A1- 2006 073 276

## Description

### [Technical Field]

The present invention relates to a coating apparatus such as an atomic layer deposition apparatus, and particularly, to an atomic layer deposition apparatus for powder coating which is applied to various deposition methods such as a chemical vapor deposition method, a molecular layer deposition method, and a combination method thereof which perform deposition by forming airflow.

### [Background Art]

An atomic layer deposition (ALD) technology is a technology of forming a film on a substrate by sequentially providing chemical materials in a gas phase and is applied to various fields.

The necessity of performing conformal coating on surfaces of powder particles is greatly emerging. For example, in order to coat battery active material particles or a catalyst with a protective layer, an ultra-thin coating technology is required which allows durability and performance of existing particles to be improved without degrading properties of the existing particles.

In order to perform the ultra-thin conformal coating, a coating technology using an atomic layer deposition method is applied to the surfaces of particles. The atomic layer deposition method is the most suitable technology for performing the ultra-thin film coating on the surfaces of the powder particles because thickness control and precise control are possible through control of a reaction cycle and coating is performed due to a surface reaction when reaction source gases are alternately sprayed to obtain a highly conformal coating property.

However, the existing coating apparatus for atomic layer deposition on surfaces of powder particles is suitable for single material coating, and thus an apparatus for consecutively coating with different kinds of materials is required.

CN 105 951 058 A describes a nanoparticle spatial separation atomic layer deposition apparatus and a method based on a fluidized bed. Nanoparticles to be coated are put in a middle part of a powder reaction cavity; the middle part of the powder reaction cavity is driven to perform an intermittent peripheral motion under driving of a power supply to pass through a first cleaning area, an absorbing area, a second cleaning area and a reaction area in sequence; coating film layers are formed on the surfaces of the nanoparticles; and a film thickness is obtained through circular motion.

US 2006/073276 A1 describes a method and apparatus for producing a thin film on a substrate set in a moving substrate holder. Within a deposition chamber, a substrate is moved across a series of dedicated deposition zones and is subjected to repeated surface reactions with at least two different reactants. The reactants are fed into the dedicated deposition zones from a gas supply system that may include high speed valves that are timed to coordinate with the passage of the substrate so as to inject reactive gases repeatedly into the deposition zones. The dedicated deposition zones are separated by dedicated exhaust zones that direct each reactive gas along separate paths so as to minimize or eliminate mixing of different reactive species in the exhaust thus decreasing deposition within the exhaust system.

The invention is defined in the independent claim. Embodiments of the invention are defined in the dependent claims.

### [Technical Problem]

The present invention is directed to providing a coating apparatus capable of consecutively coating surfaces of powder particles with different kinds of materials.

### [Technical Solution]

One aspect of the present invention provides a coating apparatus including an outer chamber including a rotating shaft, one or more reactors disposed in the outer chamber, connected to the rotating shaft, disposed to be movable to a first position and a second position in the outer chamber, and including powder accommodation spaces, a first deposition part including a first supply part, which is provided to be detachably coupled to the reactor positioned at the first position in the outer chamber and sprays one or more kinds of source gases to the accommodation space to form a first deposition layer when installed in the reactor, and a first pumping part which is detachably coupled to the reactor connected to the first supply part and performs exhausting on the accommodation space, and a second deposition part including a second supply part, which is detachably coupled to the reactor positioned at the second position in the outer chamber and sprays one or more kinds of source gases to the accommodation space to form a second deposition layer when installed in the reactor, and a second pumping part, which is detachably coupled to the reactor connected to the second supply part and performs exhausting on the accommodation space.

### [Advantageous Effects]

As described above, a coating apparatus according to at least one embodiment of the present invention has the following effects.

Surfaces of powder particles can be consecutively coated with different kinds of materials through an atomic layer deposition method.

Specifically, since reactors rotate to move to deposition positions around a rotating shaft, the surfaces of the powder particles can be consecutively coated with the different kinds of materials.

In addition, in a case in which the same powder particles are charged in the plurality of reactors, since different materials are deposited in each of the reactors, the same powder particles can be simultaneously coated with the different kinds of materials.

In addition, in a case in which different basic materials are charged in the plurality of reactors, coating with the same or different materials can be performed in each of the reactors.

### [Description of Drawings]

FIG. 1 is a schematic view illustrating a coating apparatus according to one embodiment of the present invention.
FIG. 2 is a schematic view for describing movement of reactors in an outer chamber.
FIG. 3 is a schematic view illustrating one operation state of the coating apparatus according to one embodiment of the present invention.
FIG. 4 is a schematic view illustrating main components of the coating apparatus according to one embodiment of the present invention.

### [Modes of the Invention]

Hereinafter, a coating apparatus (also referred to as an "atomic layer deposition apparatus") will be described in detail with reference to the accompanying drawings.

In addition, components that are the same or correspond to each other regardless of reference numerals are referred to by the same or similar reference numerals and redundant descriptions thereof will be omitted, and sizes and shapes of the illustrated components may be exaggerated or reduced for convenience of description.

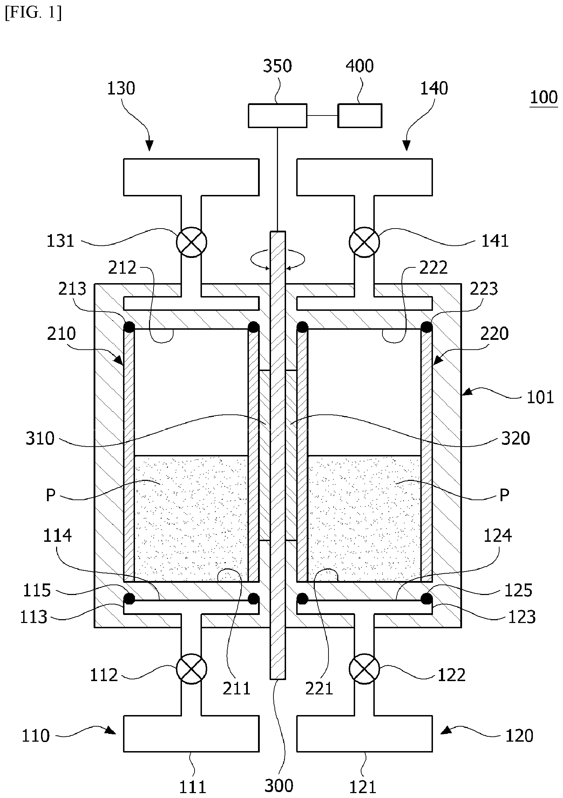

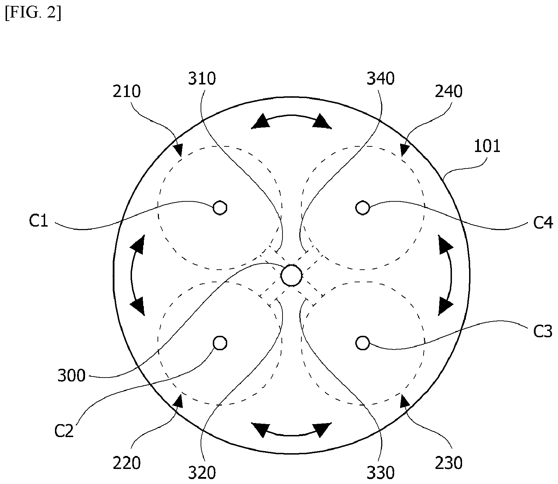

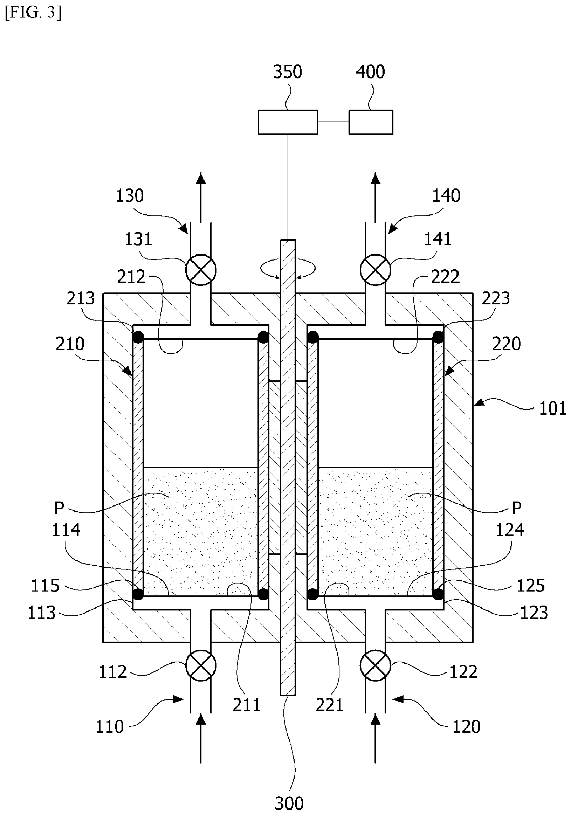

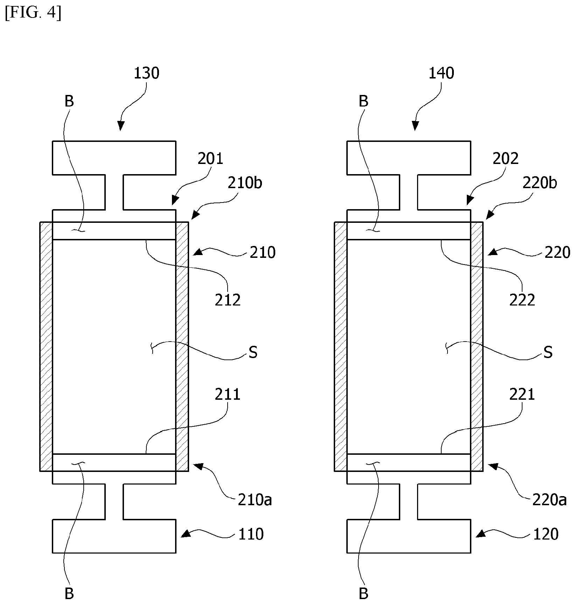

FIG. 1 is a schematic view illustrating a coating apparatus 100 according to one embodiment of the present invention, FIG. 2 is a schematic view for describing movement of reactors 210, 220, 230, and 240 in an outer chamber 101, FIG. 3 is a schematic view illustrating one operation state of the coating apparatus according to one embodiment of the present invention, and FIG. 4 is a schematic view illustrating main components of the coating apparatus according to one embodiment of the present invention.

The coating apparatus 100 (hereinafter, also referred to as "atomic layer deposition apparatus") may be used to perform coating on a surface of powder P. The atomic layer deposition apparatus 100 includes the outer chamber 101, one or more reactors 210, 220, 230, and 240, first deposition parts 110 and 130, and second deposition parts 120 and 140.

The atomic layer deposition apparatus 100 includes the outer chamber 101 having a rotating shaft. The outer chamber 101 may include a center shaft 300 and have, for example, a cylindrical shape having a central axis. The center shaft 300 may be rotatably disposed in the outer chamber 101, and the center shaft 300 may be the rotating shaft.

A predetermined space is provided in the outer chamber 101, and one or more reactors, which will be described below, are disposed around the center shaft 300 in the predetermined space in a circumferential direction. In FIGS. 1 and 2, an example in which the plurality of reactors, for example, four reactors, are disposed around the center shaft 300 in the circumferential direction is illustrated.

The atomic layer deposition apparatus 100 may include the plurality of reactors 210, 220, 230, and 240 disposed in the outer chamber 101. Each of the one or more reactors 210, 220, 230, and 240 is disposed around the center shaft of the outer chamber 101 to be movable to a first position and a second position in the outer chamber 101 in the circumferential direction. The number of reactors disposed in the outer chamber 101 may be one or more, that is, one or two or more.

Referring to FIG. 2, the first position and the second position in the specification denote arbitrary positions which are sequentially positioned in the circumferential direction (a clockwise direction or counterclockwise direction in FIG. 2) around the center shaft of the outer chamber 101. For example, when the plurality of reactors 210, 220, 230, and 240 are referred to as first to fourth reactors 210, 220, 230, and 240, a region in which the first reactor 210 is positioned in the outer chamber 101 may be referred to as the first position, and a region in which the second reactor 220 is positioned in the outer chamber 101 may be referred to as the second position.

In addition, each of the reactors may rotate to move to a predetermined position around the center shaft of the outer chamber 101 in the circumferential direction in the outer chamber. To this end, the plurality of reactors 210, 220, 230, and 240 are connected to a first driving part 350 such as a motor. The first driving part 350 may be connected to a controller 400 and controlled by the controller 400.

Specifically, the center shaft 300 is connected to the first driving part 350 and rotated by the first driving part 350. In addition, the reactors 210, 220, 230, and 240 may be connected to the center shaft 300 through connecting members 310, 320 330, and 340, respectively. In addition, the reactors 210, 220, 230, and 240 may be fixed integrally with the connecting members 310, 320 330, and 340, or the reactors 210, 220, 230, and 240 may be detachably installed on the connecting members 310, 320 330, and 340 unlike the above case.

Each of the reactors 210, 220, 230, and 240 has an accommodation space configured to accommodate the powder P. In addition, each of the reactors may have a cylindrical shape having a center shaft C1, C2, C3, or C4.

The atomic layer deposition apparatus 100 includes a first deposition part 201 and a second deposition part 202. In the first deposition part 201, one or more kinds of source gases may be sprayed to form a first deposition layer on the surface of the powder, and in the second deposition part 202, one or more kinds of source gases may be sprayed to form a second deposition layer on the surface of the powder.

The first and second deposition parts 201 and 202 are provided to spray different deposition materials onto the powder in accommodation spaces S. The first deposition part 201 and the second deposition part 202 are provided to supply different source gases to the accommodation spaces of the reactors. That is, the first and second deposition layers of different materials may be deposited on the surface of the powder by the first and second deposition parts 201 and 202. For example, a source gas with trimethylaluminium (TMA) and H₂O may be used in the first deposition part 201, and a source gas with TiCl₄ and H₂O may be used in the second deposition part 202. In addition, various combinations of an oxide, a nitride, sulfide, and a single element may be used as source gases.

The first deposition part 201 includes a first supply part 110 provided to be detachably coupled to, for example, the reactor 210 positioned at the first position in the outer chamber 101 and configured to spray one or more kinds of source gas into the accommodation space S to form the first deposition layer when installed in the reactor and a first pumping part 130 detachably coupled to the reactor 210 connected to the first supply part 110 and configured to perform exhausting on the accommodation space S. For example, the first pumping part 130 may provide a negative pressure to the accommodation space S to perform the exhausting on the accommodation space.

The first supply part 110 and the first pumping part 130 may come into contact with (be coupled to) or be separated from the reactor by vertically moving along the center shaft of the reactor (or outer chamber).

In addition, the first supply part 110 and the first pumping part 130 may be connected to a second driving part (for example, a motor or cylinder) for moving (for example, lifting).

The second deposition part 202 includes a second supply part 120 provided to be detachably coupled to, for example, the reactor 220 positioned at the second position in the outer chamber 101 and configured to spray one or more kinds of source gas into the accommodation space to form the second deposition layer when installed in the reactor 220 and a second pumping part 140 detachably coupled to the reactor 220 connected to the second supply part 120 and configured to perform exhausting on the accommodation space. For example, the second pumping part 140 may provide a negative pressure to the accommodation space to perform the exhausting on the accommodation space S.

In addition, the second supply part 120 may come into contact with (be coupled to) or be separated from the reactor by vertically moving along the center shaft of the reactor (or outer chamber). In addition, the second pumping part 140 may come into contact with (be coupled to) or be separated from the reactor by vertically moving along the center shaft of the reactor (or outer chamber).

In addition, the second supply part 120 and the second pumping part 140 are connected to a third driving part (for example, a motor or a cylinder) for lifting.

Meanwhile, each of the reactors 210, 220, 230, and 240 includes a first end portion 210a or 220a to be selectively connected to the first or second supply part according to a position (first position or second position) in the outer chamber and a second end portion 210b or 220b, which is disposed in a direction opposite to the first end portion 210a or 220a, to be selectively connected to the first or second pumping part.

In FIG. 1, the first end portions 210a and 220a refer to end portions at lower sides of the reactors 210 and 220, and the second end portions 210b and 220b refer to end portions at upper side of the reactors 210 and 220, respectively. In this case, the first end portions 210a and 220a and the second end portions 210b and 220b may be open to the outside. That is, each of the reactors 210, 220, 230, and 240 may be a hollow cylinder of which upper and lower end portions are open. In this case, the accommodation space for the powder P is positioned between the first end portion and the second end portion.

In addition, each of the reactors may include porous meshes 211 and 221 or 212 and 222 disposed in the first end portion and the second end portion. Each of the reactors may include the porous meshes in upper and lower portions thereof to prevent powder particles P from being lost during a pumping process and a coating process of the particles P.

Particularly, when the first or second supply part 110 or 120 is coupled to the reactor, the porous mesh 211 or 221 at a side of the first end portion 210a or 220a may be disposed so that a buffer space B is formed between the porous mesh 211 or 221 and the corresponding supply part 110 or 120.

In addition, when the first or second pumping part 130 or 140 is coupled to the reactor, the porous mesh 212 or 222 at a side of the second end portion 210b or 220b may be disposed so that a buffer space B is formed between the porous mesh 212 or 222 and the corresponding pumping part 130 or 140.

A sealing member 115 or 213 disposed in a coupling region is provided in one of first end portions of the reactor coupled to the first or second supply part, and an insertion groove into which the sealing member 115 or 213 is inserted may be provided in the remaining one thereof. Similarly, a sealing member 213 or 223 disposed in a coupling region is provided in one of the first or second pumping part 130 or 140 and the second end portion of the reactor, and an insertion groove into which the sealing member 213 or 223 is inserted may be provided in the remaining one.

That is, O-rings for sealing of the reactor when the source supply part and the pumping part are in contact with the reactor may be disposed in outer upper and lower portions of the reactor, and grooves into which the O-rings are inserted may be formed therein.

In FIG. 1, an example in which the sealing member is provided at a side of the first or second supply part and the insertion groove is provided at the side of the first end portion of the reactor is illustrated, and an example in which the sealing member is provided at the side of the first end portion and the insertion groove is provided at a side of the first or second pumping part is illustrated, but the present invention is not limited thereto.

Referring to FIGS. 1 and 3, the first and second supply parts 110 and 120 may be positioned at lower end sides of the reactors, and the pumping parts may be positioned on upper ends of the reactors. In addition, two or more supply parts may be provided, and two or more pumping parts may also be provided. However, the supply parts and the pumping parts only vertically move along the center shaft of the outer chamber and do not move in the circumferential direction around the center shaft of the outer chamber unlike the reactor.

Specifically, one reactor (first reactor) 210 may be coupled to the first supply part and the first pumping part at the first position and may move from the first position to the second position to be coupled to the second supply part and the second pumping part. In this structure, the surface of the powder P may be coated with different kinds of materials.

Referring to FIGS. 1 and 3, when the first supply part 120 and the first pumping part 130 are coupled to the reactor 210, the powder particles P may be floated by an inert gas supplied at a predetermined pressure from a lower portion of the reactor 210, and the surfaces of the particles P may be coated with the source (precursor) gas being supplied. In this case, the inert gas may also be supplied through the supply part in a state in which the inert gas is mixed with the source gas.

For example, kinds of materials deposited in the first reactor 210 and the second reactor 220 positioned at the first position and the second position may be different, and coating processes in the first and second reactors may be performed simultaneously.

In addition, since the reactors rotate around the center shaft of the outer chamber and are coupled to the first and second supply parts which supply different source gases, the surfaces of the particles may be coated with a plurality of different materials, thereby coating the surfaces of the particles with multiple layers.

The first and second supply parts 110 and 120 may include accommodation parts 111 and 121 in which two or more kinds of source gases and purge gases are accommodated, spray parts 114 and 124 coupled to the accommodation parts and configured to spray the source gases and the purge gases into the accommodation spaces, and valves 112 and 122 provided between the accommodation parts and the spray parts. The accommodation part may include a plurality of accommodation spaces partitioned from each other, and the source gases and the purge gases may be accommodated in the accommodation spaces. In addition, two kinds of source gases are accommodated in the different accommodation spaces.

Each of the first and second supply parts may be provided to spray any one source gas, then spray a purge gas, and spray another source gas into the accommodation space. That is, each of the first deposition part and the second deposition part is provided to form a deposition layer on the surface of the powder P through an atomic layer deposition method.

In addition, the first and second supply parts 110 and 120 may include sealing blocks 113 and 123 for sealing the sides of the first end portions of the reactors, and the spray parts 114 and 124 for spraying the source gases into the accommodation spaces may be respectively provided in the sealing blocks 113 and 123. In addition, the sealing members or the insertion grooves may be provided in the sealing blocks 113 and 123. Diameters of the sealing blocks 113 and 123 may be the same as outer diameters of the reactors.

In addition, the first and second supply parts 110 and 120 respectively include the valves 112 and 122 for supplying or blocking the source gases and the purge gases.

In addition, the first and second pumping parts 130 and 140 include valves 131 and 141 for exhausting or blocking the gases, respectively.

In addition, the reactor may be provided to move from the first position to the second position in a state in which the first supply part and the first pumping part are separated from the reactor, and when the first supply part and the first pumping part are separated from the reactor, each of the valves may be maintained in a closed state. Similarly, the reactor may be provided to move from the second position to the first position in the state in which the second supply part and the second pumping part are separated from the reactor, and when the second supply part and the second pumping part are separated from the reactor, each of the valves may be maintained in the closed state.

That is, when the reactor rotates to move, each of the valves of the supply part and the pumping part is maintained in the closed state.

In addition, after a deposition process is completed in each of the first and second deposition parts, when the reactor rotates to move, a pressure inside the reactor and a pressure inside the outer chamber need to be synchronized in order to separate the supply part and the pumping part from the reactor.

The above-described exemplary embodiment of the present invention is disclosed to exemplify the present invention and may be variously changed, modified, and added to by those skilled in the art within the scope of the appended claims.

### [Industrial Applicability]

According to a coating apparatus related to one embodiment of the present invention, surfaces of powder particles may be consecutively coated with different kinds of materials through an atomic layer deposition method.

## Claims

1. A coating apparatus (100) comprising:
an outer chamber (101) including a rotating shaft (300);
one or more reactors (210, 220, 230, 240) disposed in the outer chamber (101), connected to the rotating shaft (300), disposed to be movable to a first position and a second position in the outer chamber (101), and including powder accommodation spaces (S);
a first deposition part (110, 130; 201) including a first supply part (110), which is provided to be detachably coupled to the reactor (210) positioned at the first position in the outer chamber (101) and sprays one or more kinds of source gases into the accommodation space (S) to form a first deposition layer when installed in the reactor (210), and a first pumping part (130) which is detachably coupled to the reactor (210) connected to the first supply part (110) and performs exhausting on the accommodation space (S); and
a second deposition part (120, 140; 202) including a second supply part (120), which is detachably coupled to the reactor (220) positioned at the second position in the outer chamber (101) and sprays one or more kinds of source gases into the accommodation space (S) to form a second deposition layer when installed in the reactor (220), and a second pumping part (140) which is detachably coupled to the reactor (220) connected to the second supply part (120) and performs exhausting on the accommodation space (S),
wherein,
each of the first and the second pumping part (130, 140) includes a valve (131, 141).

2. The coating apparatus of claim 1, wherein the first deposition part (110, 130; 201) and the second deposition part (120, 140; 202) are provided to supply the different source gases to the accommodation spaces (S) of the reactors (210, 220).

3. The coating apparatus of claim 1, wherein the reactor (210, 220, 230, 240) includes:
a first end portion (210a, 220a) configured to be selectively connected to the first (110) or second supply part (120); and
a second end portion (210b, 220b) disposed in a direction opposite to the first end portion (210a, 220a) and configured to be selectively connected to the first (130) or second (140) pumping part,
wherein the first end portion (210a, 220a) and the second end portion (210b, 220b) are open to the outside, and
the accommodation space (S) is positioned between the first end portion (210a, 220a) and the second end portion (210b, 220b).

4. The coating apparatus of claim 3, wherein the reactor (210, 220) includes a porous mesh (211, 221; 212, 222) disposed on each of the first end portion (210a, 220a) and the second end portion (210b, 220b).

5. The coating apparatus of claim 4, wherein, when the first or second supply part (110, 120) is coupled to the reactor (210, 220), the porous mesh (211, 221) at a side of the first end portion (210a, 220a) is disposed so that a buffer space (B) is formed between the porous mesh (211, 221) and the supply part (110, 120).

6. The coating apparatus of claim 4, wherein, when the first or second pumping part (130, 140) is coupled to the reactor (210,220), the porous mesh (212, 222) at a side of the second end portion (210b, 220b) is disposed so that a buffer space (B) is formed between the porous mesh (212, 222) and the pumping part (130, 140).

7. The coating apparatus of claim 3, wherein:
a sealing member (115, 125) disposed in a coupling region is provided on one of the first or second supply part (110, 120) and the first end portion (210a, 220a) of the reactor (210, 220); and
an insertion groove into which the sealing member (115, 125) is inserted is provided in the remaining one thereof.

8. The coating apparatus of claim 3, wherein:
a sealing member (213, 223) disposed in a coupling region is provided on one of the first or second pumping part (130, 140) and the second end portion (210b, 220b) of the reactor (210, 220); and
an insertion groove into which the sealing member (213, 223) is inserted is provided in the remaining one thereof.

9. The coating apparatus of claim 1, wherein each of the first and the second supply parts (110, 120) includes:
an accommodation part (111, 121) configured to accommodate two or more kinds of source gases and purge gases;
a spray part (114, 124) connected to the accommodation part and configured to spray the source gases and the purge gases into the accommodation space (S); and
a valve (112, 122) provided between the accommodation part (111, 121) and the spray part (111, 121).

10. The coating apparatus of claim 9, wherein each of the first and second supply parts (110, 120) is provided to spray any one source gas, then spray the purge gas, and spray another source gas to the accommodation space (S).

11. The coating apparatus of claim 1, wherein the reactor (210) is provided to move from the first position to the second position in a state in which the first supply part (110) and the first pumping part (130) are separated from the reactor (210).

12. The coating apparatus of claim 11, wherein, when the first supply part (110) is separated from the reactor (210), a valve (112) is maintained in a closed state.

13. The coating apparatus of claim 11, wherein, when the first pumping part (130) is separated from the reactor (210), the valve (131) of the first pumping part (130) is maintained in a closed state.

14. The coating apparatus of claim 1, wherein the reactor (220) is provided to move from the second position to the first position in a state in which the second supply part (120) and the second pumping part (140) are separated from the reactor (220).

15. The coating apparatus of claim 14, wherein, when the second supply part (120) and the second pumping part (140) are separated from the reactor (220), the valve (141) of the second pumping part (140) and a valve (122) of the second supply part (120) are maintained in a closed state.

## Patentansprüche

1. Beschichtungsvorrichtung (100) aufweisend:
eine äußere Kammer (101) mit einer Drehwelle (300);
einen oder mehrere Reaktoren (210, 220, 230, 240), die in der äußeren Kammer (101) angeordnet sind, mit der Drehwelle (300) verbunden sind, angeordnet sind, um in eine erste Position und eine zweite Position in der äußeren Kammer (101) bewegbar zu sein, und Pulveraufnahmeräume (S) aufweisen;
einen ersten Abscheidungsteil (110, 130; 201) mit einem ersten Zuführteil (110), der bereitgestellt ist, um lösbar mit dem Reaktor (210) gekoppelt zu sein, der an der ersten Position in der äußeren Kammer (101) positioniert ist, und eine oder mehrere Arten von Quellgasen in den Aufnahmeraum (S) sprüht, um eine erste Abscheidungsschicht zu bilden, wenn er in dem Reaktor (210) installiert ist, und einem ersten Pumpteil (130), der lösbar mit dem Reaktor (210) gekoppelt ist, der mit dem ersten Zuführteil (110) verbunden ist, und einen Auslass an dem Aufnahmeraum (S) durchführt; und
einen zweiten Abscheidungsteil (120, 140; 202) mit einem zweiten Zuführteil (120), der lösbar mit dem Reaktor (220) gekoppelt ist, der an der zweiten Position in der äußeren Kammer (101) positioniert ist, und eine oder mehrere Arten von Quellgasen in den Aufnahmeraum (S) sprüht, um eine zweite Abscheidungsschicht zu bilden, wenn er in dem Reaktor (220) installiert ist, und einem zweiten Pumpteil (140), der lösbar mit dem Reaktor (220) gekoppelt ist, der mit dem zweiten Zuführteil (120) verbunden ist, und einen Auslass an dem Aufnahmeraum (S) durchführt,
wobei
jeder des ersten und des zweiten Pumpteils (130, 140) ein Ventil (131, 141) aufweist.

2. Beschichtungsvorrichtung nach Anspruch 1, wobei der erste Abscheidungsteil (110, 130; 201) und der zweite Abscheidungsteil (120, 140; 202) bereitgestellt sind, um die verschiedenen Quellgase den Aufnahmeräumen (S) der Reaktoren (210, 220) zuzuführen.

3. Beschichtungsvorrichtung nach Anspruch 1, wobei der Reaktor (210, 220, 230, 240) aufweist:
einen ersten Endabschnitt (210a, 220a), der konfiguriert ist, um selektiv mit dem ersten (110) oder zweiten Zuführungsteil (120) verbunden zu sein; und
einen zweiten Endabschnitt (210b, 220b), der in einer Richtung gegenüber dem ersten Endabschnitt (210a, 220a) angeordnet ist und konfiguriert ist, um selektiv mit dem ersten Pumpteil (130) oder dem zweiten Pumpteil (140) verbunden zu sein,
wobei der erste Endabschnitt (210a, 220a) und der zweite Endabschnitt (210b, 220b) nach außen offen sind, und
der Aufnahmeraum (S) zwischen dem ersten Endabschnitt (210a, 220a) und dem zweiten Endabschnitt (210b, 220b) positioniert ist.

4. Beschichtungsvorrichtung nach Anspruch 3, wobei der Reaktor (210, 220) ein poröses Netz (211, 221; 212, 222) aufweist, das an jedem des ersten Endabschnitts (210a, 220a) und des zweiten Endabschnitts (210b, 220b) angeordnet ist.

5. Beschichtungsvorrichtung nach Anspruch 4, wobei, wenn der erste oder zweite Zuführteil (110, 120) mit dem Reaktor (210, 220) gekoppelt ist, das poröse Netz (211, 221) an einer Seite des ersten Endabschnitts (210a, 220a) so angeordnet ist, dass ein Pufferraum (B) zwischen dem porösen Netz (211, 221) und dem Zuführteil (110, 120) gebildet wird.

6. Beschichtungsvorrichtung nach Anspruch 4, wobei, wenn der erste oder zweite Pumpteil (130, 140) mit dem Reaktor (210, 220) gekoppelt ist, das poröse Netz (212, 222) an einer Seite des zweiten Endabschnitts (210b, 220b) so angeordnet ist, dass ein Pufferraum (B) zwischen dem porösen Netz (212, 222) und dem Pumpteil (130, 140) gebildet wird.

7. Beschichtungsvorrichtung nach Anspruch 3, wobei:
ein Dichtungselement (115, 125), das in einem Kopplungsbereich angeordnet ist, an einem des ersten Zuführteils oder des zweiten Zuführteils (110, 120) und des ersten Endabschnitts (210a, 220a) des Reaktors (210, 220) bereitgestellt ist; und
eine Einsetznut, in die das Dichtungselement (115, 125) eingesetzt ist, in einer der anderen bereitgestellt ist.

8. Beschichtungsvorrichtung nach Anspruch 3, wobei:
ein Dichtungselement (213, 223), das in einem Kopplungsbereich angeordnet ist, an einem des ersten Pumpteils oder des zweiten Pumpteils (130, 140) und des zweiten Endabschnitts (210b, 220b) des Reaktors (210, 220) bereitgestellt ist; und
eine Einsetznut, in die das Dichtungselement (213, 223) eingesetzt ist, in einer der anderen bereitgestellt ist.

9. Beschichtungsvorrichtung nach Anspruch 1, wobei jeder des ersten Zuführteils und des zweiten Zuführteils (110, 120) aufweist:
einen Aufnahmeteil (111, 121), der konfiguriert ist, um zwei oder mehr Arten von Quellgasen und Spülgasen aufzunehmen;
einen Sprühteil (114, 124), der mit dem Aufnahmeteil verbunden ist und konfiguriert ist, um die Quellgase und die Spülgase in den Aufnahmeraum (S) zu sprühen; und
ein Ventil (112,122), das zwischen dem Aufnahmeteil (111, 121) und dem Sprühteil (111, 121) bereitgestellt ist.

10. Beschichtungsvorrichtung nach Anspruch 9, wobei jeder des ersten Zuführteils und des zweiten Zuführteils (110, 120) bereitgestellt ist, um ein beliebiges Quellgas zu sprühen, dann das Spülgas zu sprühen und ein anderes Quellgas in den Aufnahmeraum (S) zu sprühen.

11. Beschichtungsvorrichtung nach Anspruch 1, wobei der Reaktor (210) bereitgestellt ist, um sich in einem Zustand, in dem der erste Zuführteil (110) und der erste Pumpteil (130) von dem Reaktor (210) getrennt sind, von der ersten Position in die zweite Position zu bewegen.

12. Beschichtungsvorrichtung nach Anspruch 11, wobei, wenn der erste Zuführteil (110) von dem Reaktor (210) getrennt ist, ein Ventil (112) in einem geschlossenen Zustand gehalten wird.

13. Beschichtungsvorrichtung nach Anspruch 11, wobei, wenn der erste Pumpteil (130) von dem Reaktor (210) getrennt ist, das Ventil (131) des ersten Pumpteils (130) in einem geschlossenen Zustand gehalten wird.

14. Beschichtungsvorrichtung nach Anspruch 1, wobei der Reaktor (220) bereitgestellt ist, um sich in einem Zustand, in dem der zweite Zuführteil (120) und der zweite Pumpteil (140) von dem Reaktor (220) getrennt sind, von der zweiten Position in die erste Position zu bewegen.

15. Beschichtungsvorrichtung nach Anspruch 14, wobei, wenn der zweite Zuführteil (120) und der zweite Pumpteil (140) von dem Reaktor (220) getrennt sind, das Ventil (141) des zweiten Pumpteils (140) und ein Ventil (122) des zweiten Zuführteils (120) in einem geschlossenen Zustand gehalten werden.

## Revendications

1. Appareil de revêtement (100) comprenant :
une chambre extérieure (101) dotée d'un arbre rotatif (300) ;
un ou plusieurs réacteurs (210, 220, 230, 240) disposés dans la chambre extérieure (101), raccordés à l'arbre rotatif (300), disposés de façon à pouvoir être déplacés dans une première position et une deuxième position dans la chambre extérieure (101), et comprenant des espaces de réception de poudre (S) ;
un premier élément de dépôt (110, 130 ; 201) comprenant un premier élément d'alimentation (110) agencé de façon à être couplé de façon amovible au réacteur (210) placé dans la première position dans la chambre extérieure (101), et pulvérisant un ou plusieurs types de gaz sources dans l'espace de réception (S) pour constituer une première couche de dépôt lorsqu'il est installé dans le réacteur (210), et un premier élément de pompage (130) couplé de façon amovible au réacteur (210) raccordé au premier élément d'alimentation (110) et effectuant le refoulement sur l'espace de réception (S) ; et
un deuxième élément de dépôt (120, 140 ; 202) comprenant un deuxième élément d'alimentation (120) couplé de façon amovible au réacteur (220) placé dans la deuxième position dans la chambre extérieure (101), et pulvérisant un ou plusieurs types de gaz sources dans l'espace de réception (S) pour constituer une deuxième couche de dépôt lorsqu'il est installé dans le réacteur (220), et un deuxième élément de pompage (140) couplé de façon amovible au réacteur (220) raccordé au deuxième élément d'alimentation (120) et effectuant le refoulement sur l'espace de réception (S),
chacun du premier et du deuxième éléments de pompage (130, 140) comprenant un clapet (131, 141).

2. Appareil de revêtement selon la revendication 1, le premier élément de dépôt (110, 130 ; 201) et le deuxième élément de dépôt (120, 140 ; 202) étant agencés de façon à introduire les différents gaz sources dans les espaces de réception (S) des réacteurs (210, 220).

3. Appareil de revêtement selon la revendication 1, le réacteur (210, 220, 230, 240) comprenant :
une première partie terminale (210a, 220a) configurée pour être raccordée de façon sélective au premier (110) ou au deuxième (120) élément d'alimentation ; et
une deuxième partie terminale (210b, 220b) disposée dans une direction opposée à la première partie terminale (210a, 220a), et configurée pour être raccordée de façon sélective au premier (130) ou au deuxième (140) élément de pompage,
la première partie terminale (210a, 220a) et la deuxième partie terminale (210b, 220b) étant ouvertes vers l'extérieur, et
l'espace de réception (S) étant positionné entre la première partie terminale (210a, 220a) et la deuxième partie terminale (210b, 220b).

4. Appareil de revêtement selon la revendication 3, le réacteur (210, 220) comprenant une maille poreuse (211, 221 ; 212, 222) disposée sur chacune de la première partie terminale (210a, 220a) et de la deuxième partie terminale (210b, 220b).

5. Appareil de revêtement selon la revendication 4, le premier ou le deuxième élément d'alimentation (110, 120) étant couplé au réacteur (210, 220), la maille poreuse (211, 221) sur un côté de la première partie terminale (210a, 220a) étant disposée de façon à former un espace tampon (B) entre la maille poreuse (211, 221) et l'élément d'alimentation (110, 120).

6. Appareil de revêtement selon la revendication 4, le premier ou le deuxième élément de pompage (130, 140) étant couplé au réacteur (210, 220), la maille poreuse (212, 222) sur un côté de la deuxième partie terminale (210b, 220b) étant disposée de façon à former un espace tampon (B) entre la maille poreuse (212, 222) et l'élément de pompage (130, 140).

7. Appareil de revêtement selon la revendication 3,
un élément d'étanchéité (115, 125), disposé dans une zone de couplage, étant agencé sur l'un du premier ou du deuxième élément d'alimentation (110, 120) et de la première partie terminale (210a, 220a) du réacteur (210, 220) ; et
une cannelure d'insertion, dans laquelle l'élément d'étanchéité (115, 125) est inséré, étant agencée sur l'autre de ces derniers.

8. Appareil de revêtement selon la revendication 3,
un élément d'étanchéité (213, 223), disposé dans une zone de couplage, étant agencé sur l'un du premier ou du deuxième élément de pompage (130, 140) et de la deuxième partie terminale (210b, 220b) du réacteur (210, 220) ; et
une cannelure d'insertion, dans laquelle l'élément d'étanchéité (213, 223) est inséré, étant agencée sur l'autre de ces derniers.

9. Appareil de revêtement selon la revendication 1, chacun du premier et du deuxième éléments d'alimentation (110, 120) comprenant :
un élément de réception (111, 121) configuré pour recevoir deux ou plusieurs types de gaz source et de gaz de purge ;
un dispositif de pulvérisation (114, 124) raccordé à l'élément de réception et configuré pour pulvériser les gaz source et les gaz de purge dans l'espace de réception (S) ; et
un clapet (112, 122) agencé entre l'élément de réception (111, 121) et le dispositif de pulvérisation (114, 124).

10. Appareil de revêtement selon la revendication 9, chacun du premier et du deuxième éléments d'alimentation (110, 120) étant agencé pour pulvériser un gaz source quelconque, puis pulvériser le gaz de purge, et pulvériser un autre gaz source dans l'espace de réception (S).

11. Appareil de revêtement selon la revendication 1, le réacteur (210) étant agencé de façon à se déplacer de la première position à la deuxième position dans un état dans lequel le premier élément d'alimentation (110) et le premier élément de pompage (130) sont séparés du réacteur (210).

12. Appareil de revêtement selon la revendication 11, dans lequel, lorsque le premier élément d'alimentation (110) est séparé du réacteur (210), un clapet (112) est maintenu dans un état fermé.

13. Appareil de revêtement selon la revendication 11, dans lequel, lorsque le premier élément de pompage (130) est séparé du réacteur (210), le clapet (131) du premier élément de pompage (130) est maintenu dans un état fermé.

14. Appareil de revêtement selon la revendication 1, le réacteur (220) étant agencé de façon à se déplacer de la deuxième position à la première position dans un état dans lequel le deuxième élément d'alimentation (120) et le deuxième élément de pompage (140) sont séparés du réacteur (220).

15. Appareil de revêtement selon la revendication 14, dans lequel, lorsque le deuxième élément d'alimentation (120) et le deuxième élément de pompage (140) sont séparés du réacteur (220), le clapet (141) du deuxième élément de pompage (140) et un clapet (122) deuxième élément d'alimentation (120) sont maintenus dans un état fermé.
